# EUROPEAN PATENT SPECIFICATION

(11) **EP 1 837 671 B1**
(45) Date of publication and mention of the grant of the patent: **12.07.2017**
(21) Application number: 06114801.1
(22) Date of filing: 31.05.2006
(51) Int. Cl.: G01R 31/36, H03M 1/10

(54) **Fault detection method and apparatus**
Verfahren und Vorrichtung zur Fehlerdetektion
Procédé et appareil de détection de défauts

(30) Priority: 24.03.2006 US 785537 P
(43) Date of publication of application: 26.09.2007
(73) Proprietor: Rockwell Automation Limited, Milton Keynes Buckinghamshire MK11 3DR (GB)
(72) Inventor: Meagher, Thomas, Bruce, Houston, TX Texas 77084 (US)
(74) Representative: Williams, Michael David

(56) References cited:
- WO-A-03/107019
- US-A1- 2004 125 007
- US-A1- 2005 154 945
- US-A1- 2005 174 273
- US-A1- 2005 248 477
- US-B1- 6 557 131
- US-B1- 6 653 963
- DESIGN&ELEKTRONIK: "Sigma-Delta-ADC in Software" DESIGN&ELEKTRONIK, 1998, pages 1-18, XP002398239

## Description

### BACKGROUND

### a. Field of the Invention

This invention relates to fault detection in electrical circuits, in particular it relates to fault detection for a plurality of adjacent input circuits.

In safety control systems, fault tolerance is of utmost importance. Fault tolerance is the ability to continue functioning in the event of one or more failures within the system.

Fault tolerance may be achieved by a number of different techniques, each with its specific advantages and disadvantages. One example of fault tolerance is known as Hardware Implemented Fault Tolerance (HIFT). HIFT means that the system relies on robust hardware circuits (as opposed to complex software algorithms) to perform the fault detection and redundancy management functions. A significant advantage HIFT has over software-implemented fault tolerance is that HIFT eliminates the overhead for communications between processors, leaving more time for controlling the process. This makes HIFT systems significantly faster and more dependable than systems using software-implemented fault tolerance.

An example of a HIFT system is a system which provides redundancy, in particular Triple Modular Redundancy (TMR). Using TMR, critical circuits are triplicated and perform identical functions simultaneously and independently. The data output from each of the three circuits is voted in a majority-voting circuit, before affecting the system's outputs. If one of the triplicated circuits fails, its data output is ignored. However, the system continues to output to the process the value (voltage, current level, or discrete output state) that agrees with the majority of the functional circuits. TMR provides continuous, predictable operation.

HIFT and TMR provides for automatic fault recovery with no disruption to system operation and ensures minimal fault detection periods.

Another approach to fault tolerance is the use of hot-standby modules. This approach provides a level of fault tolerance whereby the standby module maintains system operation in the event of module failure. With this approach there may be some disruption to system operation during the changeover period if the modules are not themselves fault-tolerant.

Fault tolerant systems ideally create a Fault Containment Region (FCR) to ensure that a fault within the FCR boundary does not propagate to the remainder of the system. This enables multiple faults to co-exist on different parts of a system without affecting operation.

Fault tolerant systems generally employ dedicated hardware and software test and diagnostic regimes that provide very fast fault recognition and response times to provide a safer system.

Commonly, it is possible to repair faults without interrupting system operation (known as hot replacement). For example active and standby module may operate in parallel so that if an active module becomes faulty there is an automatic change over to a standby module.

Safety control systems are generally designed to be 'fail-operational/fail-safe'. Fail operational means that when a failure occurs, the system continues to operate: it is in a fail-operational state. The system should continue to operate in this state until the failed module is replaced and the system is returned to a fully operational state.

An example of fail safe operation occurs, for example if, in a TMR system, a failed module is not replaced before a second failure in a parallel circuit occurs, the second failure should cause the TMR system to shut down to a fail-safe state.

Typical safety control applications include emergency and safety shutdown systems, process control, reactor control, wellhead control, turbine and compressor control, fire and gas detection and abatement, and are applicable to many industries including oil and gas production and refining, chemical production and processing, power generation, paper and textile mills and sewage treatment plants.

Patent Application No. US 2005/154945 describes a method and device for testing an analogue to digital convertor to test for errors that may occur when more than one reference voltage may be used for conversion by different convertors in the same system.

Design & Elektronic 1988 pages 1-18 describes a Sigma-Delta analogue to digital convertor in software.

Patent Application No. US 2004/0125007 describes an analogue to digital convertor which includes an internally generated analogue signal and when a digital signal generated from an external analogue signal is equal to a digital signal generated from the internal signal a fault signal is generated.

### SUMMARY OF THE INVENTION

According to the invention there is provided a method for detecting one or more errors in at least one of a global reference clock signal (Sample Clock Pulse), a pulse width modulated test signal source and a data transport system which sends controlling signals for use with an analogue to digital converter circuit, wherein the analogue to digital converter circuit receives a first analogue input signal, the global reference clock signal and a first unique pulse width modulated test signal and includes cooperating analogue-circuit elements. The method comprising the steps of: digitally simulating said analogue to digital converter circuit using a digitally simulated circuit, the digitally simulated circuit comprising digital circuit components (2303 - 2309) which provide digital equivalents of the cooperating analogue circuit elements, wherein the digitally simulated circuit is arranged to mimic the behaviour of the analogue to digital converter circuit and to be uninfluenced by external analogue circuitry or connections, wherein the digitally simulated circuit is arranged to simulate reception of a second analogue input signal, and is further arranged to be connected to the data transport system to receive a second uniquely phased pulse width modulated test signal (Dtest) and to receive the global reference clock signal (Sample Clock Pulse) and generate an output (Data Out) functionally dependent on the global reference clock signal (Sample Clock Pulse) and the second uniquely phased pulse width modulated test signal (Dtest); driving the digitally simulated circuit with the global reference clock signal (Sample Clock Pulse) and the second uniquely phased pulse width modulated test signal (Dtest) to provide the output (Data Out); and comparing the output (Data Out) of said digitally simulated circuit with stored reference data; and generating an error condition when the output (Data Out) of said digitally simulated circuit and said stored reference data differ by more than a predetermined threshold.

According to another aspect of the invention there is also provided a system for detecting one or more errors in at least one of a global reference clock signal (Sample Clock Pulse), a pulse width modulated test signal source and a data transport system which is adapted to send controlling signals for use with an analogue to digital converter circuit, wherein the analogue to digital converter circuit is adapted to receive a first analogue input signal, the global reference clock signal and a first unique pulse width modulated test signal and includes cooperating analogue circuit elements. The system comprising: a digitally simulated circuit arranged to be connected to the data transport system to receive a second uniquely phased pulse width modulated test signal (Dtest) and arranged to receive the global reference clock signal (Sample Clock Pulse) and generate an output (Data Out) functionally dependent on the global reference clock signal (Sample Clock Pulse) and the second uniquely phased pulse width modulated test signal (Dtest); the digitally simulated circuit comprising digital circuit components (2303 - 2309) which are adapted to provide digital equivalents of the cooperating analogue circuit elements and being arranged to simulate reception of a second analogue input signal, wherein the digitally simulated circuit is arranged to mimic the behaviour of the analogue to digital converter circuit and to be uninfluenced by external analogue circuitry or connections; and a comparator for comparing the output (Data Out) from said digitally simulated circuit with stored reference data; and means for generating an error condition when the output (Data Out) of said digitally simulated circuit and said stored reference data differ by more than a predetermined threshold.

There is also described a method for detecting a control or communication fault on an analogue circuit comprising the steps of: digitally simulating said analogue circuit; driving the digitally simulated circuit with a control input also used to drive said analogue circuit; and comparing an output of said simulated circuit with a reference output and setting an error condition in the event that the compared outputs differ.

There is further described an apparatus for detecting a control or communication fault on an analogue circuit comprising: a digitally simulated circuit driven with a control input also used to drive said analogue circuit; and a comparator for comparing output data from said digitally simulated circuit with a stored reference data; and means for generating an error condition in the event that the compared outputs differ.

Preferably, said analogue circuit is an analogue to digital input circuit and said control input is a clock signal, and even more preferably said analogue circuit is a sigma-delta analogue to digital converter.

In a preferred embodiment the digitally simulated circuit receives test input data from the same source as said analogue circuit.

### BRIEF DESCRIPTION OF THE DRAWINGS

The invention will now be described, by way of example only, with reference to the accompanying drawings in which:
Figure 1 illustrates schematically a fault tolerant architecture;
Figure 2 illustrates a sigma-delta input circuit; and
Figure 3 illustrates a simulated digital reference sigma-delta input circuit.

### DETAILED DESCRIPTION

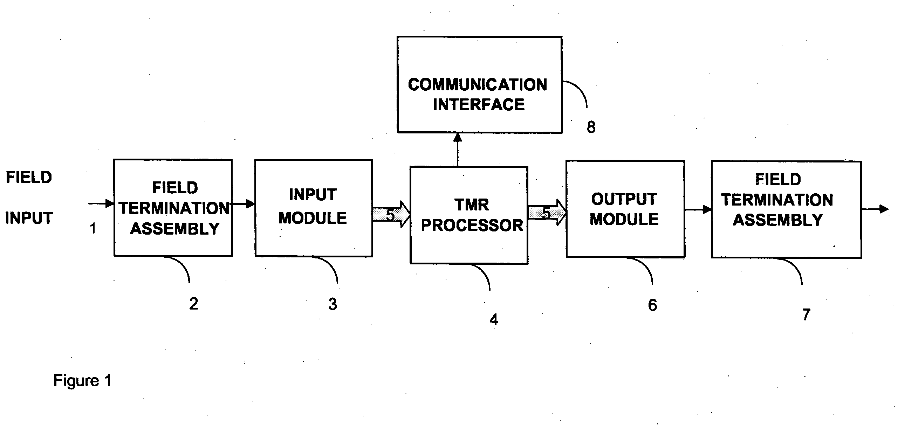

Referring now to Figure 1, signals 1 from an input field device (not shown) are connected to the system via an input Field Termination Assembly (FTA) 2. An input module 3 receives, buffers and carries out any necessary conversion of the input data from the field device. The input data is then transmitted over a triplicated Inter-Module Bus (IMB) 5 to a TMR processor 4. Triplicated microprocessors of the TMR processor receive the input data from each channel of the IMB 5 and carry out a majority vote of the data. During data processing, each of the three processors compares and majority votes its input data against that of the other two processors. The processors synchronously execute the application program, and the derived output data is transmitted back to the IMB. An output module 6 receives, majority votes, and carries out any necessary conversion of the output data from the TMR processor 4. The output circuits are then driven by the majority-voted command. The output signals are connected to a field device (not shown) via an output FTA 7. A communications interface 8 provides facilities to allow systems to be networked using peer to peer communications links, the collection of Sequence of Events (SOE) data, and connection to other systems.

If an internal circuit in the system fails, it is simply voted out. Comprehensive distributed voting both out-votes failures, preventing them from being propagated into the process, and simplifies the process of identifying where faults have occurred by means identifying the source of a discrepant value.

For safety systems it is beneficial for line monitored analogue and digital input modules to detect open circuit faults between the Field Termination Assembly (FTA) and the input module itself. The requirement also exists that any fault in the components of each input circuit should be detectable.

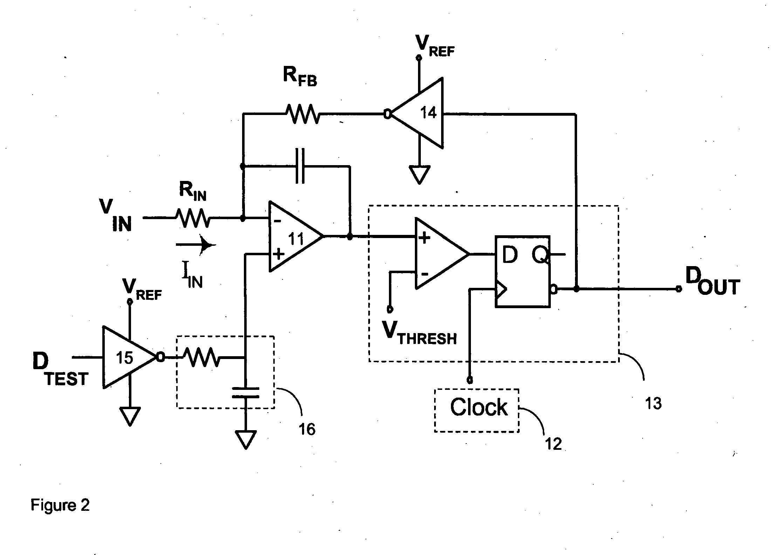

Figure 2 illustrates a sigma-delta analogue to digital (A/D) converter 10 used by the input module 3. The input module 3 comprises an array of 42x3 triplicated sigma-delta A/D converters 10. A single array of 42 sigma-delta A/D converters is referred to herein as a 'slice'. There is a dedicated A/D converter for each of the three input 'slices'. To maximize fault detection no buffers are inserted in the signal path.

The sigma-delta A/D converter 10 comprises an integrator 11, a one-bit A/D converter 13 and a one-bit D/A converter 14. A test signal D_{TEST} is converted by a one-bit D/A converter 15 and connected to a first input of the integrator 11 via an RC low pass filter 16. An input scaling resistor R_{IN} connects an input V_{IN} of the module to a second inverting input of the integrator 11. The output of the integrator 11 is converted to a digital output by the one-bit A/D converter 13. The one-bit D/A converter 14 feeds back an analogue version of the digital output to the inverting input via a feed back resistor R_{FB}.

Each sigma-delta A/D receives a global reference clock, and a unique pulse width modulated (PWM) test signal.

All of the sigma-delta A/D converters for a given input slice are controlled centrally with signals sent via a data transport system

Certain classes of faults, involving the global reference clock, test signal generation, and data transport, can result in every channel being slightly in error. Such faults can be difficult to detect when testing sigma-delta A/D converters separately or comparing output signals to those of another sigma-delta A/D converter.

In order to rapidly detect such faults, a digital model of a sigma-delta A/D converter is implemented. This functional model is connected to the global reference clock and data transport subsystem, and receives it's own uniquely phased test PWM signal. Control software receives and processes the data provided by this functional model in the same way as it does the real A/D converter channels.

Because the simulated channel is implemented digitally, the simulated D_{OUT} value should be precise. Small deviations of the computed values for the simulated channel from the established reference values are indicative of a systematic fault which can be quickly detected.

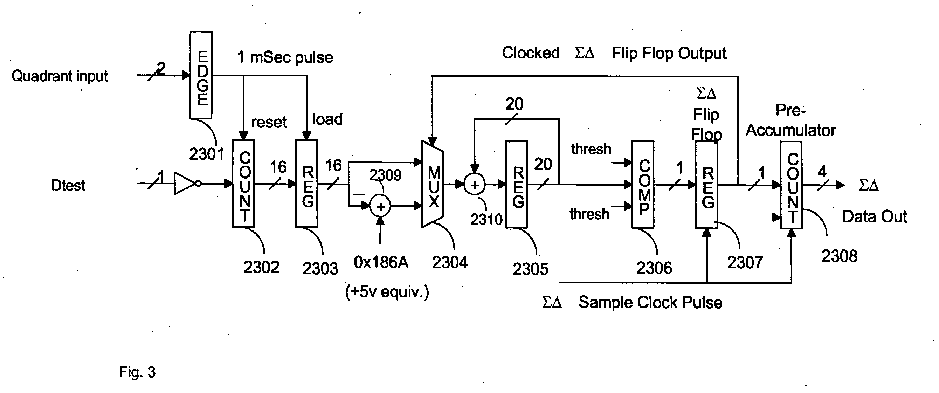

Referring now to Figure 3, a simulated digital reference circuit is shown which mimics the behaviour of an analogue Sigma Delta modulator with an open input connection.

This digital simulated circuit provides a "perfect" reference circuit that responds identically to the analogue sigma-delta input modules to pulse ratio modulation signals and clock parameters, but is uninfluenced by external analogue circuitry or connections.

The data produced by this simulated circuit is used to detect subtle faults in control and communications circuitry by comparing the output data with reference data and setting an error condition in the event that the compared data differ by more than a predetermined threshold.

A counter 2302 and a register 2303 are controlled by a signal from an edge detector 2301. The edge detector 2301 receives a quadrant input. Thus the register 2303 provides an accumulated sample value every time a quadrant input signal changes and emulates the RC filter 16 of the analogue circuit.

Two adders 2309 and 2310, a multiplexer 2304 feeding a twenty bit integrator 2305 emulate the op amp 11 of the analogue circuit.

A comparator 2306 and register 2307 simulates the A/D and D/A converters 13 and 14 of the analogue circuit. A pre-accumulator 2308 receives a signal from the register 2307 and generates a "Data Out" signal.

The "Data Out" signal is bundled with the data from the other replicated analogue channels from a slice and sent to an external DSP (not shown) for processing, indistinguishably from them. The test signal amplitude and phase data are extracted and compared to stored reference values, just as for the actual analogue channels.

It is possible to use very small comparison windows (ie only tolerate very small deviations from stored reference values) for this data because the digital nature of the sigma delta simulated circuit is inherently precise under normal unfaulted operating conditions.

It is to be recognised that various alterations, modifications, and/or additions may be introduced into the constructions and arrangements of parts described above without departing from the scope of the present invention as defined in the following claims.

## Claims

1. A method for detecting one or more errors in at least one of a global reference clock signal (Sample Clock Pulse), a pulse width modulated test signal generation source and a data transport system which sends controlling signals for use with an analogue to digital converter circuit, wherein the analogue to digital converter circuit receives a first analogue input signal, the global reference clock signal and a first unique pulse width modulated test signal and includes cooperating analogue circuit elements, the method comprising the steps of:
digitally simulating said analogue to digital converter circuit using a digitally simulated circuit, the digitally simulated circuit comprising digital circuit components (2303 - 2309) which provide digital equivalents of the cooperating analogue circuit elements, wherein the digitally simulated circuit is arranged to mimic the behaviour of the analogue to digital converter circuit and to be uninfluenced by external analogue circuitry or connections, wherein the digitally simulated circuit is arranged to simulate reception of a second analogue input signal, and is further arranged to be connected to the data transport system to receive a second uniquely phased pulse width modulated test signal (Dtest) and to receive the global reference clock signal (Sample Clock Pulse) and generate an output (Data Out) functionally dependent on the global reference clock signal (Sample Clock Pulse) and the second uniquely phased pulse width modulated test signal (Dtest);
driving the digitally simulated circuit with the global reference clock signal (Sample Clock Pulse) and the second uniquely phased pulse width modulated test signal (Dtest) to provide the output (Data Out); and
comparing the output (Data Out) of said digitally simulated circuit with stored reference data; and
generating an error condition when the output (Data Out) of said digitally simulated circuit and said stored reference data differ by more than a predetermined threshold.

2. A system for detecting one or more errors in at least one of a global reference clock signal (Sample Clock Pulse), a pulse width modulated test signal generation source and a data transport system which is adapted to send controlling signals for use with an analogue to digital converter circuit, wherein the analogue to digital converter circuit is adapted to receive a first analogue input signal, the global reference clock signal and a first unique pulse width modulated test signal and includes cooperating analogue circuit elements, the system comprising:
a digitally simulated circuit arranged to be connected to the data transport system to receive a second uniquely phased pulse width modulated test signal (Dtest) and arranged to receive the global reference clock signal (Sample Clock Pulse) and generate an output (Data Out) functionally dependent on the global reference clock signal (Sample Clock Pulse) and the second uniquely phased pulse width modulated test signal (Dtest); the digitally simulated circuit comprising digital circuit components (2303 - 2309) which are adapted to provide digital equivalents of the cooperating analogue circuit elements and being arranged to simulate reception of a second analogue input signal, wherein the digitally simulated circuit is arranged to mimic the behaviour of the analogue to digital converter circuit and to be uninfluenced by external analogue circuitry or connections; and
a comparator for comparing the output (Data Out) from said digitally simulated circuit with stored reference data; and
means for generating an error condition when the output (Data Out) of said digitally simulated circuit and said stored reference data differ by more than a predetermined threshold.

3. A system according to claim 2, in which said analogue to digital converter circuit is a sigma-delta analogue to digital converter.

## Patentansprüche

1. Verfahren zum Ermitteln von einem oder mehreren Fehlern in mindestens einem von einem globalen Referenztaktsignal (Sample Clock Pulse), einer Erzeugungsquelle für pulsweitenmodulierte Prüfsignale und einem Datentransportsystem, das Steuerungssignale zur Verwendung mit einer Analog-digital-Umsetzerschaltung sendet, worin die Analog-digital-Umsetzerschaltung ein erstes analoges Eingangssignal, das globale Referenztaktsignal und ein erstes eindeutiges pulsweitenmoduliertes Prüfsignal empfängt und zusammenwirkende analoge Schaltungselemente aufweist, wobei das Verfahren die Schritte umfasst:
digitales Simulieren der Analog-digital-Umsetzerschaltung unter Verwendung einer digital simulierten Schaltung, wobei die digital simulierte Schaltung digitale Schaltungskomponenten (2303 - 2309) umfasst, die digitale Äquivalente zu den zusammenwirkenden analogen Schaltungselementen bereitstellen, worin die digital simulierte Schaltung dafür eingerichtet ist, das Verhalten der Analog-digital-Umsetzerschaltung nachzuahmen und durch externe analoge Schaltungen oder Verbindungen unbeeinflusst zu sein, worin die digital simulierte Schaltung dafür eingerichtet ist, den Empfang eines zweiten analogen Eingangssignals zu simulieren, und ferner dafür eingerichtet ist, mit dem Datentransportsystem verbunden zu werden, um ein zweites pulsweitenmoduliertes Prüfsignal mit eindeutiger Phasenlage (Dtest) zu empfangen und das globale Referenztaktsignal (Sample Clock Pulse) zu empfangen und eine Ausgabe (Data Out) zu erzeugen, die funktionell vom globalen Referenztaktsignal (Sample Clock Pulse) und dem zweiten pulsweitenmodulierten Prüfsignal mit eindeutiger Phasenlage (Dtest) abhängig ist;
Ansteuern der digital simulierten Schaltung mit dem globalen Referenztaktsignal (Sample Clock Pulse) und dem zweiten pulsweitenmodulierten Prüfsignal mit eindeutiger Phasenlage (Dtest), um die Ausgabe (Data Out) bereitzustellen; und
Vergleichen der Ausgabe (Data Out) der digital simulierten Schaltung mit gespeicherten Referenzdaten; und
Erzeugen einer Fehlerbedingung, wenn die Ausgabe (Data Out) der digital simulierten Schaltung und die gespeicherten Referenzdaten um mehr als einen vorbestimmten Schwellenwert differieren.

2. System zum Ermitteln von einem oder mehreren Fehlern in mindestens einem von einem globalen Referenztaktsignal (Sample Clock Pulse), einer Erzeugungsquelle für pulsweitenmodulierte Prüfsignale und einem Datentransportsystem, das dafür eingerichtet ist, Steuerungssignale zur Verwendung mit einer Analog-digital-Umsetzerschaltung zu senden, worin die Analog-digital-Umsetzerschaltung dafür eingerichtet ist, ein erstes analoges Eingangssignal, das globale Referenztaktsignal und ein erstes eindeutiges pulsweitenmoduliertes Prüfsignal zu empfangen, und zusammenwirkende analoge Schaltungselemente aufweist, wobei das System umfasst:
eine digital simulierte Schaltung, die dafür eingerichtet ist, mit dem Datentransportsystem verbunden zu werden, um ein zweites pulsweitenmoduliertes Prüfsignal mit eindeutiger Phasenlage (Dtest) zu empfangen und dafür eingerichtet ist, das globale Referenztaktsignal (Sample Clock Pulse) zu empfangen und eine Ausgabe (Data Out) zu erzeugen, die funktionell vom globalen Referenztaktsignal (Sample Clock Pulse) und dem zweiten pulsweitenmodulierten Prüfsignal mit eindeutiger Phasenlage (Dtest) abhängig ist; wobei die digital simulierte Schaltung digitale Schaltungskomponenten (2303 - 2309) umfasst, die dafür eingerichtet sind, digitale Äquivalente zu den zusammenwirkenden analogen Schaltungselementen bereitstellen, worin die digital simulierte Schaltung dafür eingerichtet ist, das Verhalten der Analog-digital-Umsetzerschaltung nachzuahmen und durch externe analoge Schaltungen oder Verbindungen unbeeinflusst zu sein; und
einen Komparator zum Vergleichen der Ausgabe (Data Out) aus der digital simulierten Schaltung mit gespeicherten Referenzdaten; und
Mittel zum Erzeugen einer Fehlerbedingung, wenn die Ausgabe (Data Out) der digital simulierten Schaltung und die gespeicherten Referenzdaten um mehr als einen vorbestimmten Schwellenwert differieren.

3. System nach Anspruch 2, in dem die Analog-digital-Umsetzerschaltung ein Sigma-Delta- Analog-digital-Umsetzer ist.

## Revendications

1. Procédé pour détecter une ou plusieurs erreur(s) dans au moins une source informationnelle prise parmi un signal d'horloge de référence global (impulsion d'horloge d'échantillonnage ou Sample Clock Pulse), une source de génération de signal de test modulé en largeur d'impulsion et un système de transport de données qui envoie des signaux de commande pour une utilisation avec un circuit de convertisseur analogique-numérique, dans lequel le circuit de convertisseur analogique-numérique reçoit un premier signal d'entrée analogique, le signal d'horloge de référence global et un premier signal de test modulé en largeur d'impulsion unique et inclut des éléments de circuit analogiques coopérants, le procédé comprenant les étapes consistant à :
simuler numériquement ledit circuit de convertisseur analogique-numérique en utilisant un circuit simulé numériquement, le circuit simulé numériquement comprenant des composants de circuit numériques (2303 - 2309) qui constituent des équivalents numériques des éléments de circuit analogiques coopérants, dans lequel le circuit simulé numériquement est agencé de manière à mimer le comportement du circuit de convertisseur analogique-numérique et de manière à être non influencé par un circuit ou des connexions analogique(s) externe(s), dans lequel le circuit simulé numériquement est agencé de manière à simuler la réception d'un second signal d'entrée analogique, et est en outre agencé de manière à être connecté au système de transport de données pour recevoir un second signal de test modulé en largeur d'impulsion à phase unique (Dtest) et pour recevoir le signal d'horloge de référence global (Sample Clock Pulse) et générer une sortie (sortie de données ou Data Out) qui dépend fonctionnellement du signal d'horloge de référence global (Sample Clock Pulse) et du second signal de test modulé en largeur d'impulsion à phase unique (Dtest) ; et
piloter le circuit simulé numériquement à l'aide du signal d'horloge de référence global (Sample Clock Pulse) et du second signal de test modulé en largeur d'impulsion à phase unique (Dtest) de manière à fournir la sortie (Data Out) ; et
comparer la sortie (Data Out) qui provient dudit circuit simulé numériquement avec des données de référence stockées ; et
générer une condition d'erreur lorsque la sortie (Data Out) dudit circuit simulé numériquement et lesdites données de référence stockées diffèrent de plus d'un seuil prédéterminé.

2. Système pour détecter une ou plusieurs erreur(s) dans au moins une source informationnelle prise parmi un signal d'horloge de référence global (impulsion d'horloge d'échantillonnage ou Sample Clock Pulse), une source de génération de signal de test modulé en largeur d'impulsion et un système de transport de données qui est adapté de manière à envoyer des signaux de commande pour une utilisation avec un circuit de convertisseur analogique-numérique, dans lequel le circuit de convertisseur analogique-numérique est adapté de manière à recevoir un premier signal d'entrée analogique, le signal d'horloge de référence global et un premier signal de test modulé en largeur d'impulsion unique et il inclut des éléments de circuit analogiques coopérants, le système comprenant :
un circuit simulé numériquement qui est agencé de manière à être connecté au système de transport de données pour recevoir un second signal de test modulé en largeur d'impulsion à phase unique (Dtest) et qui est agencé de manière à recevoir le signal d'horloge de référence global (Sample Clock Pulse) et à générer une sortie (Data Out) qui dépend fonctionnellement du signal d'horloge de référence global (Sample Clock Pulse) et du second signal de test modulé en largeur d'impulsion à phase unique (Dtest) ; le circuit simulé numériquement comprenant des composants de circuit numériques (2303 - 2309) qui sont adaptés de manière à constituer des équivalents numériques des éléments de circuits analogiques coopérants et étant agencé de manière à simuler la réception d'un second signal d'entrée analogique, dans lequel le circuit simulé numériquement est agencé de manière à mimer le comportement du circuit de convertisseur analogique-numérique et de manière à être non influencé par un circuit ou des connexions analogique(s) externe(s) ; et
un comparateur pour comparer la sortie (Data Out) qui provient dudit circuit simulé numériquement avec des données de référence stockées ; et
un moyen pour générer une condition d'erreur lorsque la sortie (Data Out) dudit circuit simulé numériquement et lesdites données de référence stockées diffèrent de plus d'un seuil prédéterminé.

3. Système selon la revendication 2, dans lequel ledit circuit de convertisseur analogique-numérique est un convertisseur analogique-numérique sigma-delta.
